# EUROPEAN PATENT APPLICATION

(11) **EP 1 211 532 A2**
(43) Date of publication of application: **05.06.2002**
(21) Application number: 01309958.5
(22) Date of filing: 28.11.2001
(51) Int. Cl.: G02B 6/13, G02B 6/42

(54) **Optical device for mounting optical elements**

(30) Priority: 28.11.2000 JP 2000361374
(71) Applicant: The Furukawa Electric Co., Ltd., Tokyo 100-8322 (JP)
(72) Inventor: Nekado, Yoshinobu, The Furukawa Electric Co., Ltd., Chiyoda-ku, Tokyo 100-8322 (JP); Nara, Kazutaka, The Furukawa Electric Co., Ltd., Chiyoda-ku, Tokyo 100-8322 (JP); Kashihara, Kazuhisa, The Furukawa Electr.Co., Ltd., Chiyoda-ku, Tokyo 100-8322 (JP); Kawashima, Hiroshi, The Furukawa Electr.Co., Ltd., Chiyoda-ku, Tokyo 100-8322 (JP); Ohyama, Isao, The Furukawa Electric.Co., Ltd., Chiyoda-ku, Tokyo 100-8322 (JP)
(74) Representative: Dealtry, Brian

(57) **Abstract**

An optical device capable of optically coupling an optical element to be mounted to an optical waveguide circuit with low transmission losses is provided. On a base (20) provided with a substrate (1), a positioning pattern (15) made of a Pt film, a high melting point material having a melting point higher than a temperature of consolidating glass, is formed. Then, glass layers (24,26) are formed by depositing glass particles by flame hydrolysis deposition and consolidating the deposited glass particles. The glass layers cover the top of the positioning pattern (15) and the base (20). The glass layers on the top and the periphery of the positioning pattern (15) are removed to expose the positioning pattern (15) and the base (20) therearound. The exposed area is to be a optical element mounting face (4). The positioning pattern (15) allows a light receiving device (8) to be positioned and fixed on the optical element mounting face (4) accurately. The light receiving device (8) is allowed to be coupled to a circuit of an optical waveguide forming area (2) formed in the remaining glass layers that have not been removed.

## Description

### Field of the Invention

The present invention relates to an optical hybrid module mounted with optical elements such as a laser diode, a photodiode and an optical fiber, an optical device thereof and a semifabricated product for the optical device.

### Background of the Invention

Recently, the realization of high capacity in optical communication and high bit-rate wavelength division multiplexing, and the realization and widespread use of FTTH (Fiber to the Home) have been strongly demanded. In order to fulfill these demands, it is an essential issue to realize a high-quality, low-cost optical hybrid module configured by mounting an optical element such as a laser diode (LD), photodiode (PD) or optical fiber on a substrate.

In order to realize a low-cost optical hybrid module, manufacture of each of optical elements configuring the optical hybrid module and the ease of assembling the optical hybrid module are required. Additionally, in order to realize a high-quality optical hybrid module, it is demanded that each of optical elements configuring the optical hybrid module can be optically coupled with low connection losses and desired characteristics can be obtained.

### Summary of the Invention

In one aspect, the invention is to provide an optical device. Additionally, in another aspect, it is to provide an optical hybrid module using the optical device. Furthermore, in still another aspect, it is to provide a semifabricated product for the optical device. An optical device to be the base of each of the aspects comprises:
a base provided with a substrate;
a positioning pattern formed of a high melting point material having a melting point higher than a temperature of consolidating or annealing glass on the base; and
a glass layer formed to cover the base,
wherein the glass layer on an area for forming the positioning pattern is removed to expose and form the positioning pattern on the base, and
a face on the base where the glass layer has been removed and exposed is formed to be optical element mounting area.

### Brief Description of the Drawings

Exemplary embodiments of the invention will now be described in conjunction with drawings in which:
Fig. 1 depicts an illustration showing an optical hybrid module provided with an optical device of one embodiment in the invention;
Figs. 2A to 2H depict illustrations showing one example of a fabrication process of the optical device and the optical hybrid module shown in Fig. 1;
Figs. 3A to 3F depict illustrations showing the example of the fabrication process following Fig. 2H;
Fig. 4 depicts an illustration showing an optical hybrid module provided with an optical device of another embodiment in the invention;
Figs. 5A to 5F depict illustrations showing one example of a fabrication process of the optical device and the optical hybrid module shown in Fig. 4;
Figs. 6A to 6F depict illustrations showing the example of the fabrication process following Fig. 5F;
Figs. 7A, 7B and 7C depict sectional illustrations schematically showing air gap generation inside a glass layer having an optical waveguide circuit and a state after annealing treatment;
Figs. 8A to 8C depict sectional illustrations schematically showing a state of a deformed positioning marker accompanying high temperature processing;
Fig. 9 depicts an illustration showing a configuration of an optical hybrid module considered prior to the invention; and
Figs. 10A and 10B depict illustrations schematically showing a relationship between a space between positioning patterns and a form of anisotropic etching.

### Detailed Description

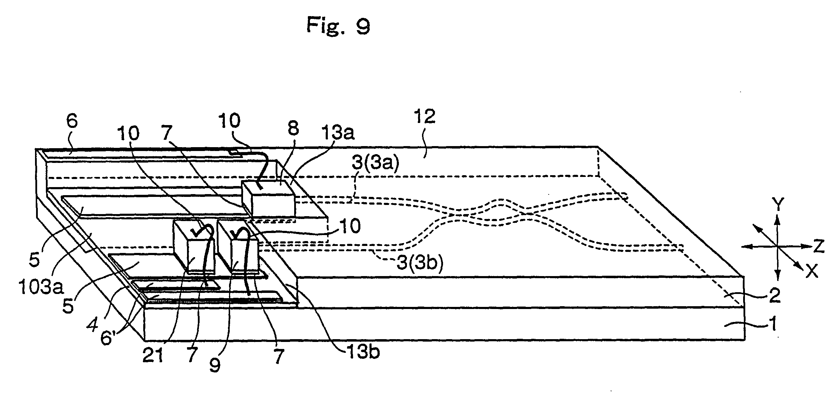

Fig. 9 depicts an example of an optical hybrid module to be considered prior to the invention. This optical hybrid module is provided with an optical device where a optical element mounting face 4 and an optical waveguide forming area 2 are formed on a substrate 1 adjacently. A step is formed on the border between the optical element mounting face 4 and a face (surface) 12 of the optical waveguide forming area 2. This step is about a few tens to a hundred µm, for example. Additionally, a light receiving device (PD: photodiode) 8, a light emitting device (LD: laser diode) 9 and a monitor PD 21 are disposed on the optical element mounting face 4.

The optical waveguide forming area 2 is provided with an optical waveguide circuit having two cores 3 (3a and 3b). The cores 3a and 3b are embedded in a cladding glass layer. Each of end faces on one side (left end faces in the drawing) of the cores 3(3a and 3b) is terminated to stepped faces 13a and 13b of the border between the optical element mounting face 4 and the optical waveguide forming area 2. The terminated face of the core (3a) faces to the light receiving part of the light receiving device 8 and the terminated face of the core (3b) faces to the light emitting part of the light emitting device 9. In this state, the core (3a) is optically coupled to the light receiving device 8 and the core (3b) is optically coupled to the light emitting device 9.

Additionally, in Fig. 9 and 103a denotes an insulating film disposed as necessary, which is formed of SiO₂. Furthermore, in the drawing, 5, 6 and 6' denote electrode wiring patterns, respectively, and 10 denotes a wiring material such as wire.

As described above, the optical hybrid module has the optical device mounted with optical elements such as the light receiving device (PD) 8, the light emitting device (LD) 9 and the monitor PD 21. The optical device is generally provided with an optical waveguide circuit, which may be configured by incorporating an electrical circuit for operating an active device (active optical element) such as the LD or PD as necessary.

Such the optical device is demanded to match the optical axis of the optical element such as the light receiving device 8 or light emitting device 9 with the optical axis of the optical circuit of the optical device (for example, the optical axis of the optical waveguide circuit) highly accurately.

In order to respond to the demand, it is considered that a positioning marker is disposed on the optical element mounting face 4 of the optical device, the positioning marker allows the light receiving device 8 and the light emitting device 9 to be positioned and they are connected to the cores 3(3a and 3b), respectively. The positioning marker can perform accurate positioning in the direction parallel to the substrate surface (horizontal direction). As the positioning marker, it is considered to apply materials such as Au, Al and Cr/Ni/Au, which are used for conventional electric wiring.

However, in the optical hybrid module as shown in Fig. 9, it has the step on the border between the optical element mounting face 4 and the face 12 of the optical waveguide forming area 2, as described above. It is difficult to form the positioning marker on the optical element mounting face 4 at accuracy of about submicrometers to a few µm with this step.

Then, the following fabrication method can be thought to overcome the difficulty of forming the positioning marker. For example, the positioning marker is formed on the optical element mounting face 4 beforehand. In this state, a glass layer for forming the optical waveguide forming area 2 is formed to cover the positioning marker and the substrate 1. Subsequently, the glass layer on the top or the peripheral area of the positioning marker is removed to obtain an optical device where the positioning marker is exposed.

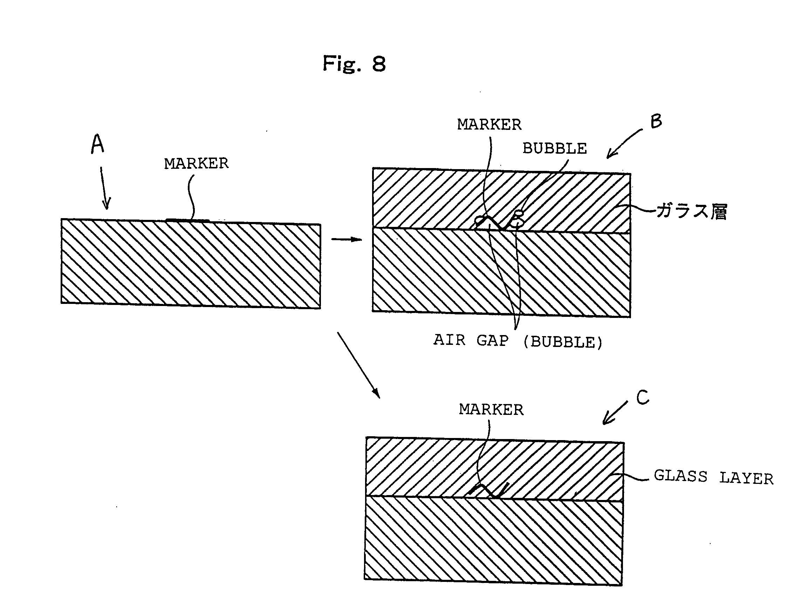

However, when the positioning marker is formed by this method, the following problem arises in the case of using flame hydrolysis deposition that is generally known as a method for forming the optical waveguide forming area 2. More specifically, glass particles are deposited by flame hydrolysis deposition and then the glass particles are consolidated. At this time, a problem occurs that bubbles are generated in the periphery of the positioning marker formed using the material for electric wiring or the positioning marker is deformed in the process of consolidation as shown in Fig. 8B.

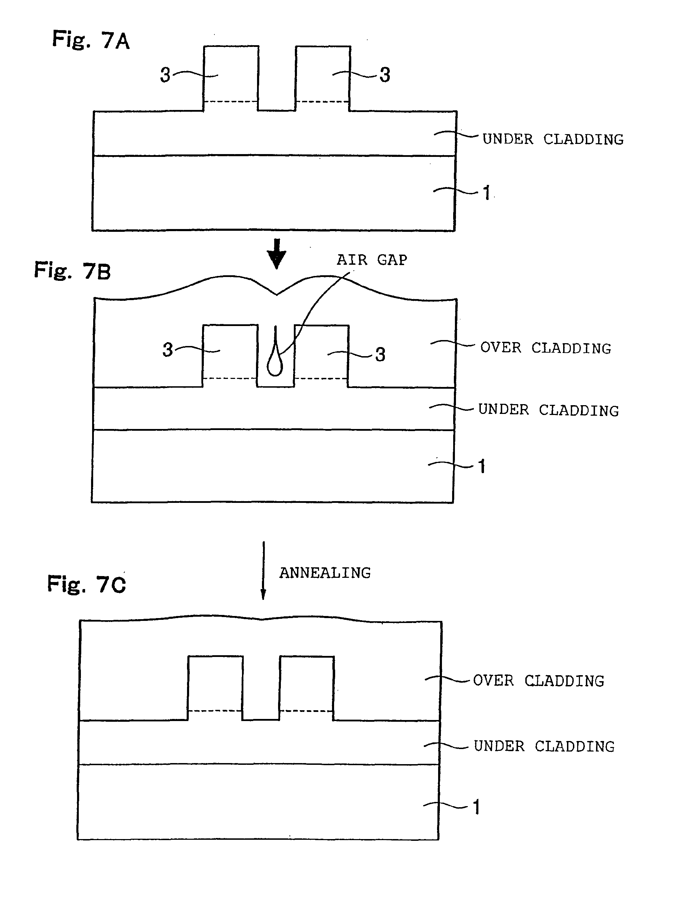

Alternatively, as a method for forming the optical waveguide forming area 2, it is also considered to use glass deposition methods such as deposition by sputtering, well-known CVD (Chemical Vapor Deposition) and EB (Electron Beam) vapor deposition. However, also in those cases, a problem arises that an air gap is generated in the over cladding between the cores 3 as shown in Fig. 7B when an over cladding is deposited over cores 3 spaced as shown in Fig. 7A. It is needed to perform annealing treatment at a temperature of 900°C or above to embed the air gap. Then, as similar to the case of flame hydrolysis deposition, a problem occurs that the positioning marker is deformed in annealing when the materials for electric wiring are adapted to the positioning marker as shown in Fig. 8C, for example.

Because of the circumstances as described above, such an optical device of high fabrication yield that can highly accurately position and dispose the light receiving device 8 and the light emitting device 9 on the optical element mounting face 4 and efficiently connect the light receiving device 8 and the light emitting device 9 to the cores 3(3a and 3b), respectively, has not been developed yet.

In one aspect, the invention is to provide an optical device that is to overcome the problem, a semifabricated product for the optical device and an optical hybrid module using the optical device.

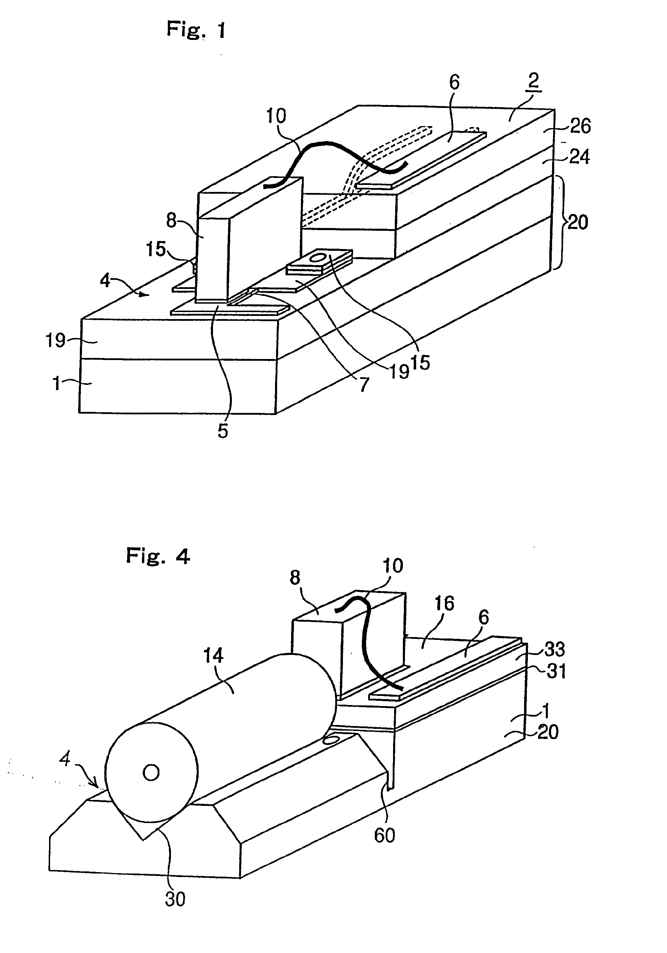

Hereafter, some embodiments of the invention will be described with reference to the drawings. Additionally, in the following description, components common to those of the example to be considered prior to the invention shown in Fig. 9 are designated the same numerals and signs. Furthermore, components common to those of each of the embodiments are designated common numerals and signs, omitting or simplifying the overlapping description of the common components. Fig. 1 depicts a first embodiment of an optical hybrid module provided with an optical device in the present invention.

The optical device of the first embodiment used in the optical hybrid module has a base 20 provided with a substrate 1, as shown in Fig. 1. The base 20 is that a base glass film 19 is formed on the top face of the substrate 1. Over the base 20 is formed with a positioning pattern 15 made of a high melting point material having a melting point higher than a temperature of consolidating glass. Then, the top of the positioning pattern 15 and the base 20 is covered with glass layers 24 and 26. Subsequently, the glass layers 24 and 26 are consolidated and then the glass layers 24 and 26 overlaying an area of forming the positioning pattern 15 are removed. The glass layers 24 and 26 are removed and thereby an area exposed is formed to be a optical element mounting face 4. The positioning pattern 15 is exposed on the optical element mounting face 4.

In the embodiment, the glass layer 24 is formed by depositing glass particles by flame hydrolysis deposition and consolidating the deposited glass particles. An optical waveguide forming area 2 is formed of the glass layer 24. The positioning pattern 15 is made of Pt, a high melting point material having a melting point of 1772°C. The optical device of the first embodiment has a configuration where the optical element mounting face 4 is formed adjacent to the optical waveguide forming area 2 on the base 20.

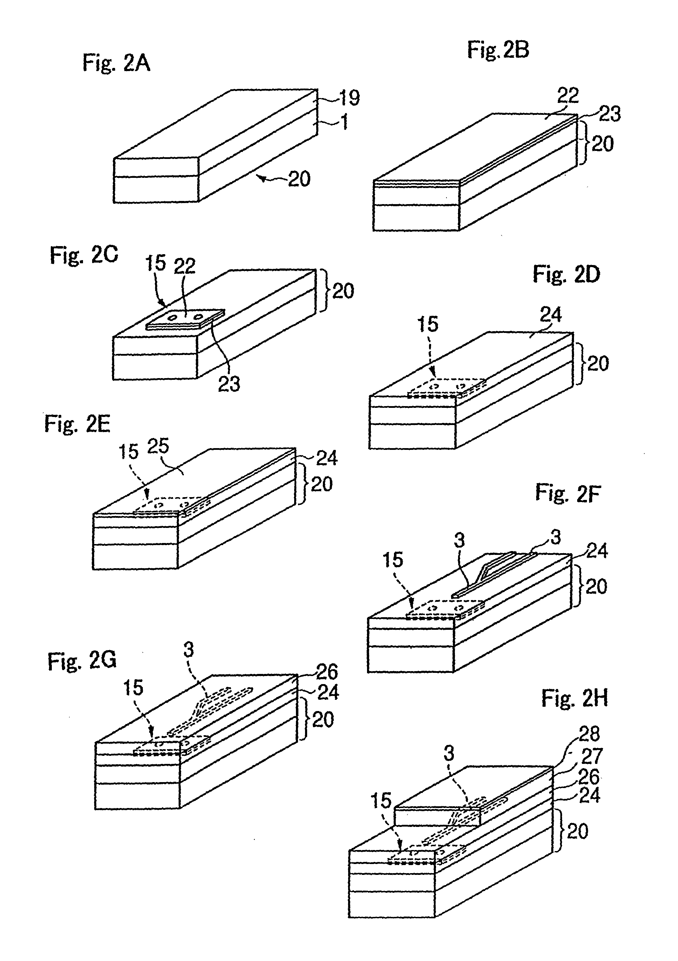

Hereafter, a method for fabricating the optical device of the first embodiment will be described in detail. First, as shown in Fig. 2A, the base glass film 19 is deposited on the substrate 1 by well-known CVD (Chemical Vapor Deposition) to form the base 20. Materials for the substrate 1 are not defined specifically, but a silicon substrate is used here. Next, as shown in Fig. 2B, a Ti film 23 having a thickness of 0.05 µm is deposited on the base 20 by sputtering as one example, and a Pt film 22 having a thickness of 0.5 µm is deposited thereon by sputtering as one example. Additionally, the thin-film Ti film 23 enhances Pt deposition properties over the base glass film 19 (it allows the Pt film to be hardly peeled off from the base glass film 19). The melting point of the Ti film 23 is a temperature of 1675°C.

After that, as shown in Fig. 2C, the Ti film 23 and the Pt film 22 are patterned by well-known photolithography and dry etching of RIE to form the positioning pattern 15.

Subsequently, as shown in Figs. 2D to 2G, glass layers having an optical waveguide circuit are formed by a process including the deposition of glass particles by flame hydrolysis deposition and the consolidation of the deposited glass particles. A product obtained until the process shown in Fig. 2G is to be a semifabricated product for an optical device.

Specifically, as shown in Fig. 2D, glass particles for an under cladding are deposited on the base 20 by flame hydrolysis deposition to form an under cladding layer 24. The under cladding layer 24 covers the positioning pattern 15. The under cladding layer 24 has a refractive index equivalent to that of the base glass film 19 in this example. Subsequently, as shown in Fig. 2E, core glass particles having a refractive index higher than that of the under cladding layer 24 are deposited on the under cladding layer 24 to form a core layer 25. Then, the under cladding layer 24 and the core layer 25 are consolidated at high temperatures of about 1100 to 1400°C.

After that, as shown in Fig. 2F, the core layer 25 is patterned to obtain cores 3. When the method for forming the cores 3 are described more specifically, first, a WSi film and an SiO₂ film, for example, are sequentially deposited on the core layer 25 by sputtering. Subsequently, a waveguide-shaped pattern drawn on a photomask is sequentially transferred into the SiO₂ film, the WSi film and the core layer 25 by well-known photolithography and dry etching of RIE to obtain the cores 3 shown in Fig. 2F.

Then, as shown in Fig. 2G, glass particles for an over cladding are deposited over the cores 3 by flame hydrolysis deposition to form an over cladding layer 26. Subsequently, the over cladding layer 26 is consolidated as similar to that described above and the semifabricated product for an optical device is obtained.

After that, as shown in Fig. 2H, a WSi film 27 and an SiO₂ film 28 are sequentially deposited on the over cladding layer 26 by sputtering. Then, the top of an area to be the optical waveguide forming area 2 (the area formed with the core 3) is masked. This method is performed in which the WSi film 27 and the SiO₂ film 28 are sequentially deposited by sputtering as similar to that described above, for example, and then a pattern drawn on a photomask is sequentially transferred into the WSi film 27 and the SiO₂ film 28 by well-know photolithography and dry etching of RIE.

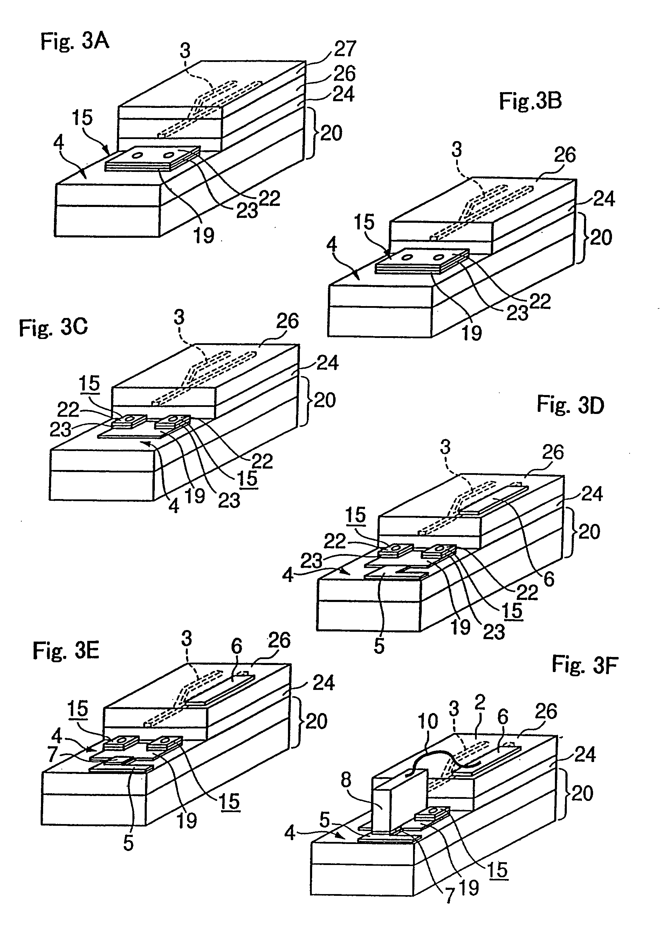

Subsequently, as shown in Fig. 3A, the glass layers on the top and the periphery of the positioning pattern 15 are removed by dry etching of well-known RIE and thereby the positioning pattern 15 and the surface of the base 20 in the periphery thereof are exposed. This exposed area is the optical element mounting face 4. Additionally, at this time, the base glass film 19 of the base 20 is partially etched in this example.

After that, as shown in Fig. 3B, the WSi film 27 is etched and removed. Furthermore, as shown in Fig. 3C, the portion to remove the Pt film 22 and the Ti film 23 of the positioning pattern 15 (the portion to mount a optical element) is removed. Moreover, finally as shown in Fig. 3D, a Cr/Ni/Au material, for example, is utilized, an electrode wiring pattern 5, 6 is formed by well-known photolithography and EB vapor deposition and the optical device is completed.

Figs. 3E and 3F depict a process for fabricating an optical hybrid module using the optical device. That is, as shown in Fig. 3E, a solder chip 7 made of SuAu is disposed at a predetermined position. Subsequently, as shown Fig. 3F, the light receiving device 8 is positioned by the positioning pattern 15 and is fixed by a solder. Then, a wiring material 10 is connected by wire bonding and thereby the optical hybrid module is fabricated.

According to the first embodiment, the positioning pattern 15 is formed of the Pt film 22, the high melting point material having a melting point higher than a temperature of consolidating glass. On this account, even though the deposited glass particles are consolidated at temperatures of about 1100 to 1400°C in forming the glass layers covering the positioning pattern 15 and the base 20, the deformation of the positioning pattern 15 and the bubble generation around the positioning pattern 15 can be suppressed. Accordingly, the optical device having the accurate positioning pattern 15 can be formed.

Particularly, when an optical device is formed as described above using the positioning pattern of the Pt material, the wettability of the glass layer to the Pt film becomes excellent in forming the glass layer on Pt. Therefore, the deformation of the positioning pattern and the bubble generation can surely be suppressed. The inventor has first revealed this by experiment.

Additionally, according to the first embodiment, the accurate positioning pattern 15 having a planar surface with no deformation is formed on the optical element mounting face 4 as described above. Then, as shown in Fig. 3C, the portion to remove the positioning pattern 15, which is to be a portion for mounting an optical element (the light receiving device 8), is removed and thereby a optical element mounting face with no deformation in the height direction of the substrate 1 can be formed.

Accordingly, in the first embodiment, the accurate positioning pattern 15 is utilized and the light receiving device 8 can be precisely positioned in both the horizontal and vertical directions to the substrate surface, that is, three-dimensionally. Thus, an excellent optical device capable of coupling the light receiving device 8 to an optical waveguide circuit (the cores 3) in the optical waveguide forming area 2 with low transmission losses can be formed.

Additionally, according to the first embodiment, the base 20 is formed by disposing the base glass film 19 over the substrate 1 and the top of the base glass film 19 is formed to be the optical element mounting face 4. Therefore, an electrical capacitance between the substrate 1 and the light receiving device 8, which exerts influence upon the operating characteristics of the light receiving device 8, can be reduced. Accordingly, the operating characteristics of an optical element (the light receiving device 8 here) to be mounted on the optical element mounting face 4 can be made excellent.

Furthermore, according to the first embodiment, glass particle deposition using flame hydrolysis deposition is adapted to forming the optical waveguide forming area 2. Thus, the thick cladding glass layers 24 and 26 can be formed easily and an optical waveguide circuit with low optical transmission losses can be fabricated.

Next, a second embodiment of the optical device in the invention will be described. The points different from the first embodiment are in that glass layers are formed by any one of glass depositions of sputtering and vapor deposition and the glass layers are annealed. Except these, it is similar to the first embodiment, and the positioning pattern is formed of a high melting point material having a melting point higher than a temperature of annealing glass. Here, the description overlapping the first embodiment is omitted.

In the second embodiment, the under cladding layer 24 shown in Fig. 2D and the core layer 25 shown in Fig. 2E are formed by well-known CVD. After the core layer 25 is formed, the core is patterned as similar to the first embodiment. Then, after that, the over cladding layer 26 shown in Fig. 2G is formed by CVD described above.

Subsequently, after the glass layers are formed by the method mentioned above, annealing treatment is performed at temperatures of 1100 to 1400°C and then the semifabricated product for an optical device shown in Fig. 2G is obtained. In the second embodiment, a semifabricated product for an optical device where an air gap between the cores 3 is embedded and an optical waveguide circuit as designed is formed accurately could be obtained by the annealing treatment as shown in Fig. 7C.

Also in the second embodiment, the Pt film 22, the high melting point material having a melting point of 1772°C, is adapted to the positioning pattern 15. Pt is the high melting point material higher than the annealing temperature and thus it can be suppressed that the positioning pattern 15 is deformed due to annealing treatment and bubbles are generated around the positioning pattern 15.

Then, this semifabricated product for an optical device was used to form the optical device of the second embodiment, almost similar to that of the first embodiment by the process shown in Figs. 2H to 3F.

The second embodiment can exert substantially the same effect as the first embodiment.

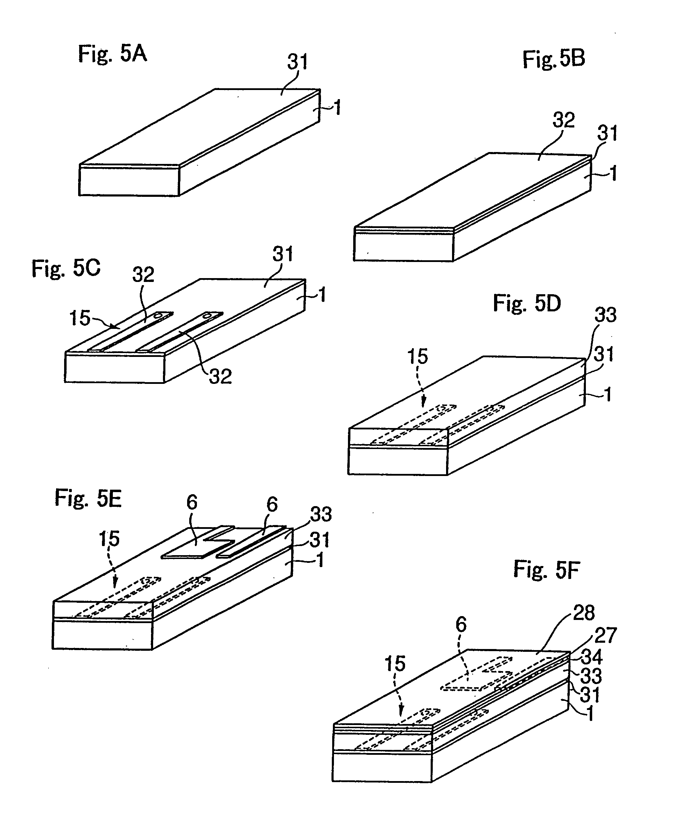

Fig. 4 depicts an optical device of a third embodiment in the invention in the form of an optical hybrid module mounted with an optical fiber 14 and a light receiving device 8.

In the optical device of the third embodiment, the top face of a glass layer 33 is formed to be a surface to mount the light receiving device 8 and a surface to form electric wiring patterns 6. Additionally, a optical element mounting face 4 is formed to be a surface to mount the optical fiber 14. Also in this optical device of the third embodiment, a step is formed on the border between the optical element mounting face 4 and the top face 16 of the glass layer 33.

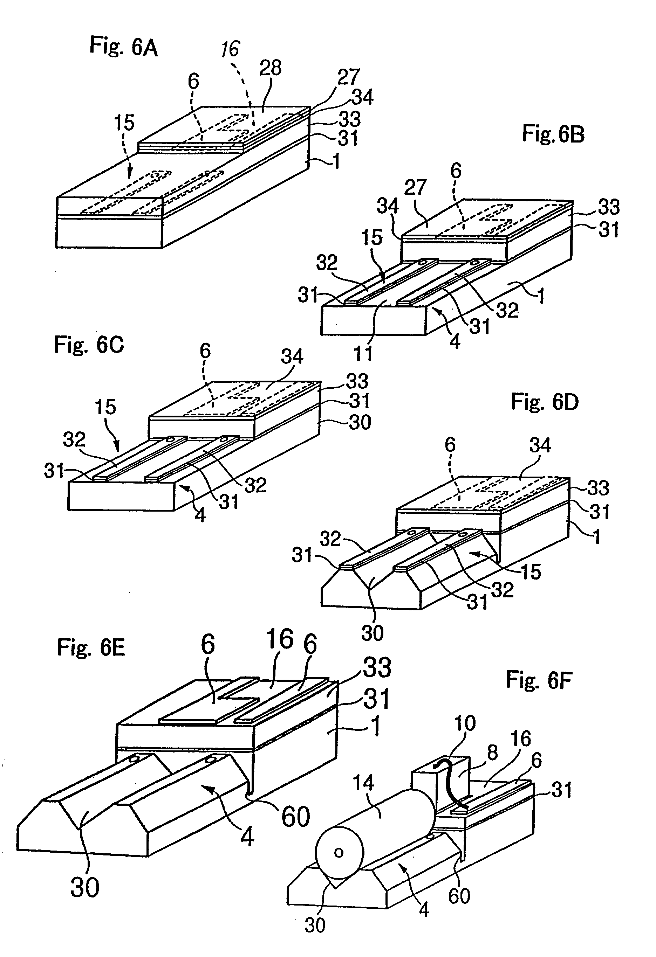

A method for fabricating the optical device of the fourth embodiment will be described with reference to Figs. 5A to 5F and 6A to 6F. First, as shown in Fig. 5A, a thermally-oxidized film 31 is formed on an Si substrate 1 (a base 20) by a well-know method. Then, as shown in Fig. 5B, an Al₂O₃ film 32 is deposited over the thermally-oxidized film 31 by sputtering.

Subsequently, as shown in Fig. 5C, the Al₂O₃ film 32 is patterned by well-known photolithography and etching and positioning patterns 15 of the Al₂O₃ film 32 are formed. The melting point of the Al₂O₃ film 32 is a temperature of 2015°C. After that, as shown in Fig. 5D, a process including the deposition of glass particles by flame hydrolysis deposition and the consolidation of the deposited glass particles is performed over the base 20 (substrate 1). By this process, the glass layer 33 having a thickness of 25 µm, for example, is formed, which functions as an insulating film. In this manner, when flame hydrolysis deposition is used, it has a high deposition rate and thus an excellent glass layer having a thickness of a few tens µm can be formed easily.

Then, as shown in Fig. 5E, the electric wiring patterns 6 are formed on the glass layer 33. The electric wiring patterns 6 are formed by photolithography and EB vapor deposition using a Cr/Ni/Au material, for example. After that, an SiO₂ film 34 and a WSi film 27 are formed on the glass layer 33 as shown in Fig. 5F. Furthermore, an SiO₂ film 28 is formed over the entire top face of the WSi film 27 by sputtering and a semifabricated product for an optical device can be obtained.

Subsequently, as shown in Fig. 6A, the WSi film 27 and the SiO₂ films 28 and 34 mask the top face 16 on the electric wiring patterns 6 side (shown in Figs. 4, 6E and 6F). This masking is performed as follows. More specifically, a well-known photoresist film is first applied to the SiO₂ film 28 on the top face 16 side. Then, a pattern drawn on a photomask is sequentially transferred into the SiO₂ film 28, the WSi film 27 and the SiO₂ film 34 by well-known photolithography and dry etching of RIE. The glass layer 33 in the area where masking is not applied is exposed by this transfer process.

Moreover, using the SiO₂ film 28 and the WSi film 27 as a mask, the glass layer 33 is etched until the surface of the substrate 1 is exposed (the SiO₂ film 28 is removed midway), as shown in Fig. 6B. The positioning patterns 15 and the base therearound (the substrate 1 here) are exposed and the exposed area is formed to be the optical element mounting face 4. In addition, at this time, the thermally-oxidized film 31 underlying the Al₂O₃ film 32 was left utilizing the existence of the Al₂O₃ film 32 having an etching rate lower than the thermally-oxidized film 31.

After that, as shown in Fig. 6C, the WSi film 27 was removed by dry etching. Then, as shown in Fig. 6D, Si of the optical element mounting face 4, which has been exposed by etching with a well-known KOH solution, was anisotropically etched and a V-shaped groove 30 for mounting an optical fiber was formed.

Then, as shown in Fig. 6E, the Al₂O₃ film 32 of the positioning patterns 15 was removed. Additionally, the unnecessary SiO₂ film 34 on the top face 16 where the optical element mounting face 4 and the electric wiring patterns 6 are formed (shown in Figs. 4, 6E and 6F) was removed by etching. Subsequently, a groove 60 was formed by dicing and the optical device was obtained.

A process for fabricating an optical hybrid module using the optical device is as follows. More specifically, as shown in Fig. 6F, the V-shaped groove 30 is substituted as the positioning pattern and the optical fiber 14 is positioned and disposed on the V-shaped groove 30. Additionally, the light receiving device 8 is mounted on the electric wiring patterns 6 through a solder material and a wiring material 10 is wire bonded. Thereby, the optical hybrid module is fabricated.

According to the third embodiment, the positioning patterns 15 are formed of the Al₂O₃ film 32, the high melting point material having a melting point higher than a temperature of consolidating glass as similar to the first embodiment. On this account, the deformation due to high temperatures or the bubble generation around the positioning patterns 15 in consolidating the glass layer can be suppressed.

Therefore, according to the third embodiment, the positioning patterns 15 are utilized and the V-shaped groove 30 for inserting the optical fiber 14 can be formed accurately. On this account, an excellent optical device capable of accurately positioning the optical fiber 14 to the light receiving device 8 can be formed.

More specifically, in the optical device of the third embodiment, the positioning patterns 15 formed as designed with no deformation are used as a mask and a recessed part (the V-shaped groove 30 here) can be formed accurately. Thus, an optical element (the optical fiber 14 here) fitting in the V-shaped groove 30 can be positioned to an optical component or optical waveguide for optical coupling with high precision.

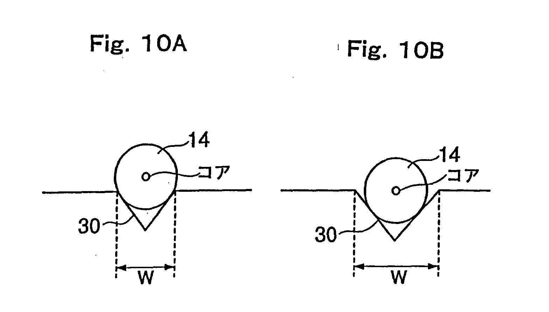

That is, when the V-shaped groove is formed by anisotropic etching of crystal, for example, a height position where a chip fits in the V-shaped groove depends on the accuracy of positioning pattern formation. More specifically, as shown in Fig. 10A, a space W between positioning patterns arranged side by side with a space each other is narrow, the depth of the V-shaped groove 30 shallows. Conversely, as shown in Fig. 10B, a space W between positioning patterns arranged side by side is wide, the depth of the V-shaped groove 30 deepens.

Then, when the optical fiber 14 as the optical element, for example, is inserted into the V-shaped groove 30, the position of the core of the optical fiber 14 becomes high as the depth of the V-shaped groove 30 shallows, whereas the position of the core of the optical fiber 14 becomes low as the depth of the V-shaped groove 30 deepens.

In the optical device of the third embodiment, the positioning patterns can be formed accurately as described above and anisotropic etching of crystal is performed utilizing the positioning patterns. Thus, the V-shaped groove can be formed highly accurately. Accordingly, the optical element fitting in the V-shaped groove can be positioned precisely in both the horizontal (horizontal plane direction) and height (vertical) directions to the substrate surface for coupling.

Particularly, when the positioning patterns of the Al₂O₃ material are used to form the optical device as described above, the wettability of the glass layer to the Al₂O₃ film becomes excellent in forming the glass layer on Al₂O₃. Accordingly, the deformation of the positioning patterns or the bubble generation can be suppressed surely. The inventor has also first revealed this by experiment as similar to the case of Pt.

Additionally, in the third embodiment, the glass layer may be formed by any one of glass depositions of sputtering and vapor deposition for annealing treatment as similar to the second embodiement. Also in this case, the Al₂O₃ film 32 is the high melting material having a melting point higher than a temperature of annealing glass. Thus, the positioning patterns 15 can be formed accurately and the same effect as that described above can be exerted.

Furthermore, the invention is not limited to each of the embodiments, which can adopt various forms. The first embodiment is the optical device that optically couples the optical waveguide circuit in the optical waveguide forming area 2 to the light receiving device 8. As an alternative example thereof, for example, other chips such as the light emitting device 9 to be mounted on the optical element mounting face 4 may be optically coupled to the optical waveguide circuit. Alternatively, an optical device may be formed that a plurality of optical elements are mounted on the optical element mounting face 4 and a predetermined plurality of optical elements, two or more among them, are optically coupled to the optical waveguide circuit.

Moreover, the forms of the optical waveguide circuit formed in the optical waveguide forming area 2 are not defined particularly; other circuit configurations can be adopted.

Besides, in the third embodiment, the optical element mounting face 4 having the V-shaped groove 30 and the electric wiring forming area are adjacently disposed in the longitudinal direction. Then, the optical fiber 14 fitting in the V-shaped groove 30 is to be coupled to the light receiving device 8 disposed on the electric wiring forming area. As the alternative example thereof, for example, the optical waveguide forming area is formed adjacent to one or both of the width direction of the optical element mounting face 4 (the direction orthogonal to the longitudinal direction of the V-shaped groove 30) and the optical fiber 14 may be optically coupled to the optical waveguide circuit in the optical waveguide forming area.

In this manner, in the optical device of the invention, the circuit configurations of the optical waveguide circuit or electric circuit are not defined particularly, which can be set properly. The invention is adapted to optical devices having various circuit configurations and thereby an excellent optical device and optical hybrid module capable of coupling a chip, optical component or optical waveguide circuit with low transmission losses can be formed as each of the embodiments.

Additionally, in the third embodiment, the recessed part formed on the optical element mounting face was formed to be the V-shaped groove 30 using the KOH solution, for example. However, the shapes of the recessed part are not defined to the V-shaped groove; various groove shapes other than the V-shaped groove can be adopted using dry etching of RIE, for example.

## Claims

1. An optical device comprising:
a base provided with a substrate;
a positioning pattern formed of a high melting point material having a melting point higher than a temperature of consolidating or annealing glass on the base; and
a glass layer formed to cover the base,
wherein the glass layer on an area for forming the positioning pattern is removed to expose and form the positioning pattern on the base, and
a face on the base where the glass layer has been removed and exposed is formed to be a optical element mounting area.

2. The optical device according to claim 1, wherein a recessed part is formed on the optical element mounting area using the positioning pattern as a mask,
wherein the recessed part is formed to be a recessed part for positioning and housing an optical element to be mounted on the optical element mounting area.

3. The optical device according to claim 2, wherein the recessed part is formed and then the positioning pattern of the high melting point material is removed, wherein the recessed part substitutes a function of the positioning pattern.

4. The optical device according to claim 1, wherein the positioning pattern is formed of at least any one of an Al₂O₃ film and a Pt film.

5. The optical device according to claim 1, wherein the glass layer is formed by depositing glass particles by flame hydrolysis deposition and consolidating the deposited glass particles.

6. The optical device according to claim 1, wherein the glass layer is formed by at least any one of glass depositions of sputtering and vapor deposition and the deposited glass layer is annealed.

7. The optical device according to claim 1, wherein the base is formed by providing a base glass film on the substrate.

8. The optical device according to claim 1, wherein the base is formed of the substrate itself.

9. The optical device according to claim 8, wherein the positioning pattern is formed on a thermally-oxidized film formed on the substrate.

10. The optical device according to claim 1, wherein the positioning pattern is formed capable of positioning an optical element to be mounted on the optical element mounting area in both horizontal and vertical directions to a substrate surface.

11. The optical device according to claim 1, wherein an optical waveguide circuit is formed on a glass layer adjacent to the optical element mounting face on the base.

12. A semifabricated product for the optical device according to claim 1 comprising:
a base provided with a substrate; and
a positioning pattern formed of a high melting point material having a melting point higher than a temperature of consolidating or annealing glass on the base,
wherein a top face of the base including the positioning pattern is covered with a deposition layer of glass particles deposited by flame hydrolysis deposition, and
the deposition layer of the deposited glass particles is consolidated.

13. A semifabricated product for the optical device according to claim 1 comprising:
a base provided with a substrate; and
a positioning pattern formed of a high melting point material having a melting point higher than a temperature of annealing glass on the base,
wherein a top face of the base including the positioning pattern is covered with a glass layer formed by using at least any one of glass depositions of sputtering and vapor deposition, and
the glass layer is annealed.

14. The semifabricated product for the optical device according to claim 12, wherein the positioning pattern is formed of at least any one of an Al₂O₃ film and a Pt film.

15. The semifabricated product for the optical device according to claim 13, wherein the positioning pattern is formed of at least any one of an Al₂O₃ film and a Pt film.

16. An optical hybrid module comprising an optical element mounted on the optical element mounting area of the optical device according to claim 11,
wherein the optical element is optically coupled to an optical waveguide circuit.

17. An optical hybrid module comprising an optical fiber as an optical element housed and disposed in the recessed part of the optical device according to claim 2,
wherein a top face of the glass layer is mounted with an optical element to be optically coupled to the optical fiber.

18. An optical hybrid module comprising an optical fiber as an optical element housed and disposed in the recessed part of the optical device according to claim 3,
wherein a top face of the glass layer is mounted with an optical element to be optically coupled to the optical fiber.

19. The optical hybrid module according to claim 17, wherein the recessed part is a recessed part formed into a V-shaped groove.

20. The optical hybrid module according to claim 18, wherein the recessed part is a recessed part formed into a V-shaped groove.
